# EUROPEAN PATENT SPECIFICATION

(11) **EP 0 331 836 B1**
(45) Date of publication and mention of the grant of the patent: **13.03.1996**
(21) Application number: 88308404.8
(22) Date of filing: 12.09.1988
(51) Int. Cl.: H03M 13/00

(54) **On-the-fly error correction apparatus**
Anordnung zur sofortigen Fehlerkorrektur
Appareil de correction simultanée d'erreurs

(30) Priority: 09.03.1988 US 166085
(43) Date of publication of application: 13.09.1989
(73) Proprietor: SEAGATE TECHNOLOGY INTERNATIONAL, Georgetown, Grand Cayman Island (KY)
(72) Inventor: Johnson, Bruce Edward, Minnetonka Minnesota 55345 (US); Tsang, Paul, Plymouth Minnesota 55441 (US)
(74) Representative: Miller, Joseph

(56) References cited:
- EP-A- 0 204 576
- EP-A- 0 218 413
- EP-A- 0 240 921
- US-A- 4 151 510
- US-A- 4 397 022
- US-A- 4 569 051
- H.Taub et al.: "Principles of Communication Systems", fourth printing, 1989, McGrawHill International Editions, pages 540-563

## Description

This invention relates to on-the-fly error correction apparatus, e.g. for magnetic recording devices, including disk drives.

"On-the-fly" error correction apparatus has not been widely incorporated into high speed magnetic recording devices, especially disk drives, for at least two reasons: unreliability caused by errors exceeding code correction and/or detection capacity, and high latency caused by the complexity of the mathematics involved in error correction, and/or the extreme complexity of the mathematics to perform on-the-fly error correction. The problems compound one another. Increasing the capacity of the code to handle errors simultaneously increases latency and complexity.

Each codeword, which conventionally comprises a complete sector, has to be de-coded and corrected prior to reading and de-coding the next codeword. Where correction takes time, the next codeword to be read and de-coded could pass a read/write head of a disk drive. This necessitates waiting one disk revolution until that codeword is again under the read/write head.

US-A-4,494,234 and US-A-4,504,948 disclose on-the-fly multi-byte error correction. However, the hardware to do so is extremely complex, employing hundreds if not thousands of exclusive-OR ("XOR") gates. The present invention seeks to provide on-the-fly error correction apparatus which is relatively simple in construction.

According to the present invention, there is provided on the fly error correction apparatus for correcting errors in codewords, grouped in multi-bit symbols, each codeword comprising encoded data and check-word symbols, said apparatus comprising
means for receiving said codewords;
means for applying a generator polynomial to each of said codewords to calculate syndromes and/or remainders and to derive therefrom a correction value and location; and
means for reading out the respective codeword from the means for receiving and if there is an error, correcting the error using the correction value and the location;
   characterised in that:
a single symbol error correcting code is used for generating said codewords;
first and second successive codewords are interleaved symbol by symbol;
said applying means processes said first and second codewords simultaneously in two parallel channels, each channel comprising a polynomial divider and means for deriving the correction value and the location.
the invention is illustrated, merely by way of example, in the accompanying drawings, in which:-
Figure 1 is an explanatory block diagram of an on-the-fly error correction apparatus;
Figure 2 is a timing diagram of an inter-leaved arrangement showing correction of a six bit error in on-the-fly error correction apparatus accordig to the invention;
Figure 3 is a block diagram of an inter-leaved de-coder of an on-the-fly error correction apparatus according to the present invention;
Figure 4 is a block diagram of a programmed logic array of the inter-leaved de-coder of Figure 3;
Figure 5 is an alternative de-coder arrangement of an on-the-fly error correction apparatus according to the present invention where a syndrome S₀ provides the error value;
Figure 6 is an alternative de-coder arrangement of an on-the-fly error correction apparatus according to the present invention where a syndrome S₀ provides an error value and a syndrome S₁ in conjunction with an error locator provides the error location;
Figure 7 is an alternative de-coder arrangement of an on-the-fly error correction apparatus according to the present invention where a syndrome S₀ provides the error value and both syndromes index an error location in a memory;
Figure 8 is an alternative de-coder arrangement of an on-the-fly error correction apparatus according to the present invention where both syndromes index both error values and locations in a memory;
Figure 9 is an alternative embodiment of an inter-leaved de-coder of an on-the-fly error correction apparatus according to the present invention;
Figure 10 is a schematic diagram of an alternative embodiment of an inter-leaved encoder/de-coder of an on-the-fly error correction apparatus according to the present invention; and
Figure 11 is a schematic diagram of an alternative inter-leaved encoder/de-coder and correction circuit of an on-the-fly error correction apparatus according to the present invention.

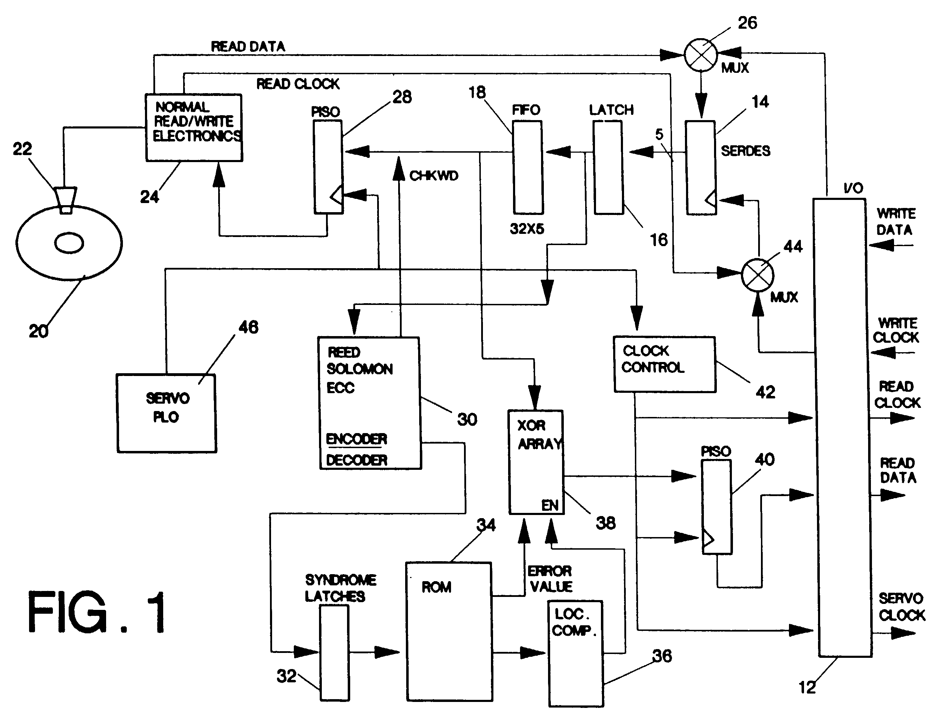

Figure 1 is a block diagram of an on-the-fly error correction apparatus for a disk drive. Data is serially input to and output from the error correction apparatus through an I/O interface 12. Read and write clocks for timing data transfer are provided and a servo clock is also provided for tracking control through this interface. Also shown are normal read/write electronics 24 for transferring actual information to and from a disk 20 of the disk drive through a transducer head 22. This circuitry generates a read clock in response to read data. A servo phase locked oscillator (PLO) 46 receives a servo input from either the transducer 22 or from a separate transducer head (not shown), and outputs a servo clock to the I/O interface 12 through a clock control 42 and to the clock input of a parallel-to-serial (PISO) converter 28 for timing write data input to the read/write electronics 24. This much of the error correction apparatus is conventional.

Serial write data is input into a serialiser/deserialiser (SERDES) 14 through a multiplexer 26 under the control of the write clock through a multiplexer 44. The SERDES outputs the write data in parallel, symbol by symbol, to a latch 16 whose output is connected to a first in/first out (FIFO) buffer 18, and to a Reed Solomon ECC encoder/de-coder 30, which divides the input signals by a generator polynomial. When the servo PLO 46 indicates that the transducer head 22 is appropriately located to write data, data symbols are clocked out of the FIFO buffer 18, in the order received, to the PISO converter 28 which provides the data serially to the read/write electronics 24. At the end of every data segment, which comprises a predetermined number of symbols, the remainder from division of the data symbols of the data segment by a generator polynomial, is clocked out of the encoder/de-coder 30 to the PISO converter 28 and appended to the data segment recorded on the disk. This remainder comprises in the present embodiment a single error correcting code employing two checkword symbols.

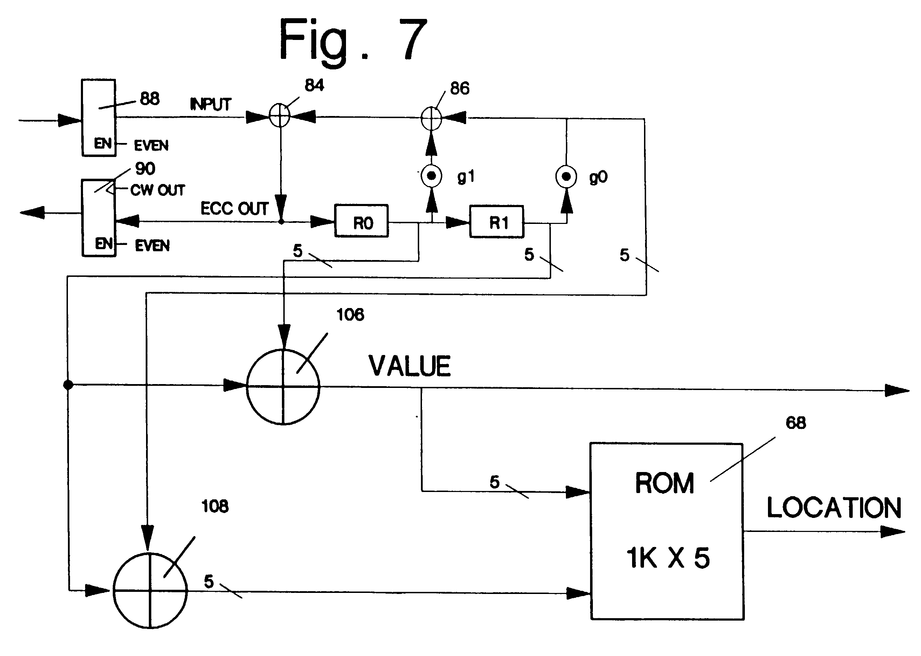

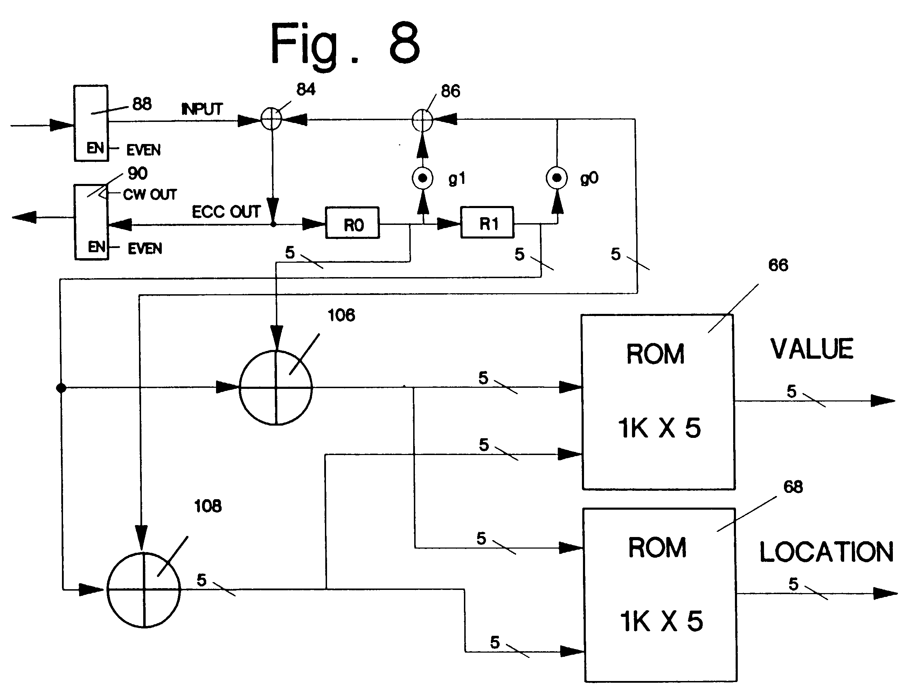

Essentially the reverse procedure is used during reading. To read data from the disk, the read/write electronics 24 first detects a sync mark denoting the beginning of a data sector. This initialises read/write timing and the read clock. Subsequent serial read data is coupled through a multiplexer 26 to the SERDES 14 under control of the read clock to the clock control 42. The SERDES converts the serial input to parallel and outputs the read data symbols through the latch 16 to the FIFO buffer 18 and the encoder/de-coder 30. The latter circuit divides to receive codeword symbols, including the checkwords, by the generator polynomial. The remainder (and the syndromes) after this division uniquely identifies both the location and value of an error. The remainder (while not technically a syndrome) is latched into syndrome latches 32, whose output index a ROM memory 34 having predetermined error values and locations uniquely associated with particular remainders. Alternatively, the syndromes may be used to look up the error values and location. This will be discussed in relation to Figures 7 and 8. The indexed error value is output to one input set of an exclusive-OR (XOR) array 38. The indexed error location is output to a location comparator 36. Thereafter, the data symbols contained in the FIFO buffer 18 are clocked, one by one, to the XOR array 38, while at the same time the location comparator 36 is clocked (which preferably is a counter which counts from the loaded count up to its maximum count). When the location comparator 36 indicates that a symbol in error is now being clocked through, it enables the output of the XOR array 38, which is the corrected read data symbol, to substitute for the read symbol in error. The read data symbols and substituted corrected read data symbols are connected to a parallel-to-serial (PISO) converter 40, which converts the symbols to serial and outputs it on the read data output of the I/O interface 12.

Note that only the information portions of a codeword are retained in the FIFO buffer 18, while the full codeword including checkwords is input to the encoder/ de-coder 30.

In one embodiment, each symbol is five bits. Thus the output of the SERDES 14 is five bits, the latch 16 is five bits, and all the PISO converters convert five bits to serial. The remainder-checkword, after both encode and de-code, comprises two five bit symbols.

Each non-zero de-code remainder uniquely identifies a single error value and location. There are 2¹⁰ different such possibilities. The ROM memory 34 therefore contains 1024 ten bit constants, each ten bits comprising a five bit error value and a five bit location number. These constants may be calculated, but are preferably determined by creating a codeword using the encoder or a simulated encoder, inducing all known possible errors in the codeword, dividing each of the erroneous codewords by the generator polynomial and associating the remainder with the known error value and location.

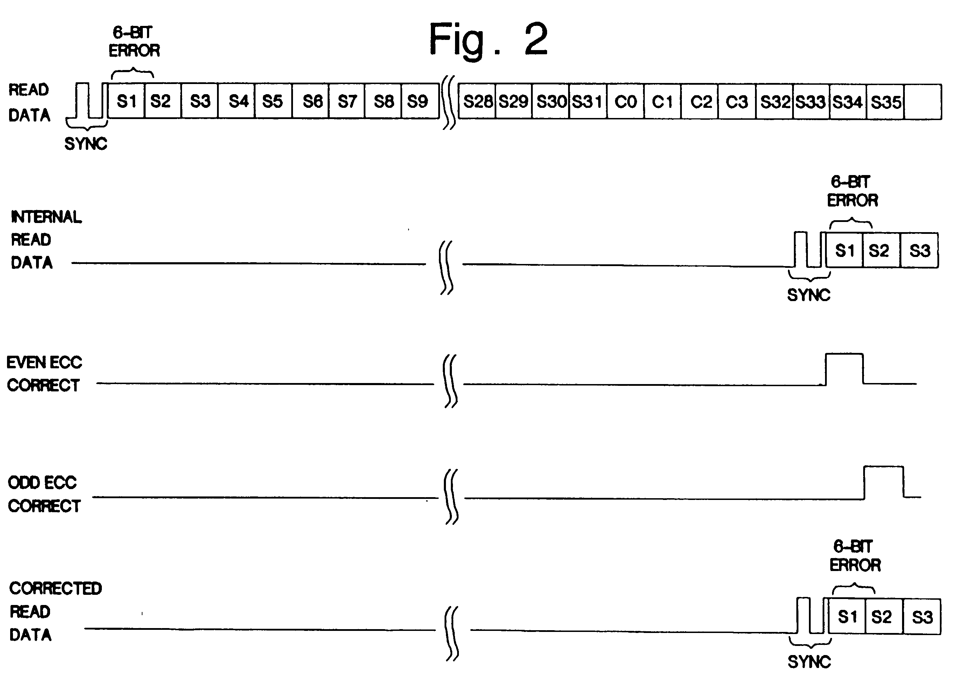

In an on-the-fly error correction apparatus according to the present invention, two codewords are inter-leaved. This permits detection of first errors in two adjacent symbols without providing a two-error correcting code. In this alternative arrangement, the information portion of each codeword comprises sixteen symbols, for a total of thirty two data symbols in the two inter-leaved codewords. The inter-leaving arrangement is shown in Figure 2. Each sector begins with a sync mark which is a predetermined bit pattern. The sync mark of a sector itself comprises the first even data symbol. This is followed by data symbols 1 - 31 and checkword symbols 0 - 3. Each odd symbol is associated with one codeword and each even symbol with another. The two codewords comprise a codeword group and are de-coded simultaneously.

Each data sector preferably contains a plurality of inter-leaved codeword groups, the number being a design choice. There is no boundary between codeword groups, as the present invention permits reading, de-coding and correction on-the-fly.

The latency period is determined by the time to de-code one codeword group, in this embodiment, thirty six symbols, plus gate delays of elements 32,34,38 and 40 of Figure 1. In Figure 2, the latency is indicated by the gap between the READ DATA line and the INTERNAL READ DATA line. Also shown in the Figure are a hypothetical six bit error in two consecutive symbols, S1 and S2, and their correction in response to separate EVEN and ODD CORRECT timing pulses from separate location de-code electronics.

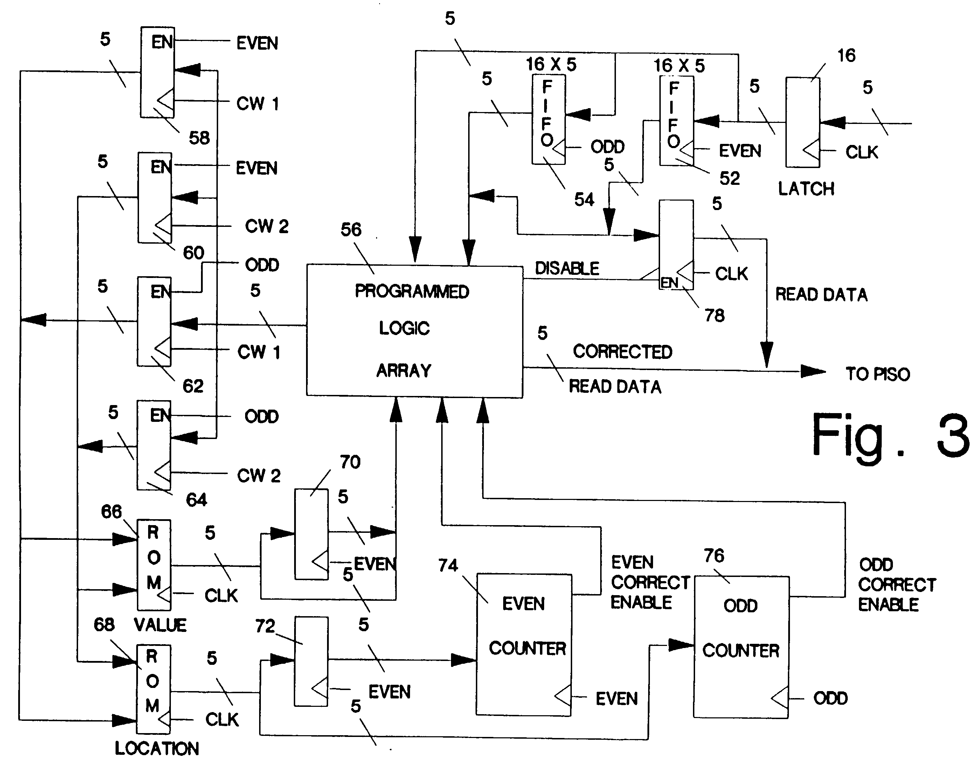

Figure 3 is a block diagram of an inter-leaved de-coder of an on-the-fly error correction apparatus according to the present invention. Data from the SERDES 14 (Figure 1) is input to the latch 16 under control of a clock from the clock control 42 which responds to the READ CLOCK from the read/write electronics 24. The input to the latch 16 comprises both inter-leaved codewords. These are input unmodified to a programmed logic (PAL) array 56 which divides them by a generator polynomial. As well the data portions of the two codewords are separated by being input to two separate FIFO buffers 52,54 under control of EVEN and ODD clocks from the clock control 42.

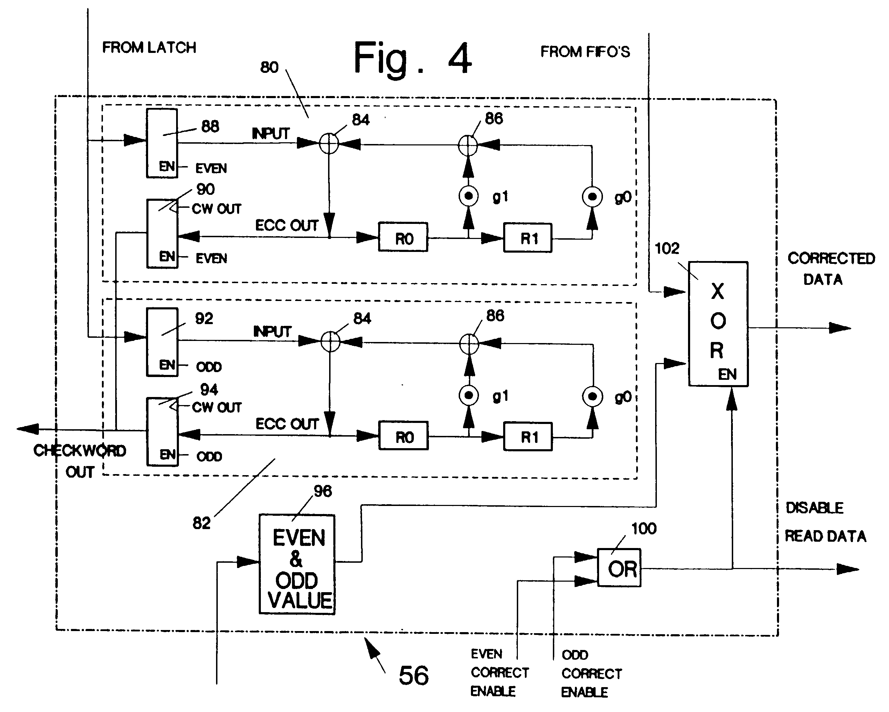

The PAL array 56 contains two generator polynomial dividers 80,82 (Figure 4) which separate the input codeword group into its components by input latches 88,92 alternately enabled again by EVEN and ODD signals from the clock control 42. Each of the generator polynomial dividers have the same general construction, an input XOR gate 84 whose other input is connected to the output of an XOR gate 86 and whose output is connected to a register R0 and an output latch 90,94. The register R0, in turn, is connected to Galois multiplier g1, whose output is connected as one input to the XOR gate 86 and to a register R1. The output of the register R1 is multiplied by a Galois multiplier g0 and provided as a second input to the XOR gate 86. As will be appreciated, this arrangement of elements provides Galois division by a generator polynomial of the form:${\text{X}}^{\text{2}} {\text{+ g}}_{\text{1}} {\text{X + g}}_{\text{0}}$

In the preferred embodiment, the generator polynomial g(X) is:${\text{X}}^{\text{2}} {\text{+ α}}^{\text{2}} {\text{X + α}}^{\text{0}}$ from roots α¹⁵ and α¹⁶, where αⁱ is a m-tuple field element of GF(2⁵) modulo P(X) = X⁵ + X + 1. Thus, g1 = α = 00100, and g0 = α⁰ = 00001, where 00100, for example, are the co-efficients of the m-tuple${\text{α}}^{\text{i}} {\text{= A}}_{\text{4}} {\text{α}}^{\text{4}} {\text{+ A}}_{\text{3}} {\text{α}}^{\text{3}} {\text{+ A}}_{\text{2}} {\text{α}}^{\text{2}} {\text{+ A}}_{\text{1}} {\text{α}}^{\text{1}} {\text{+ A}}_{\text{0}} {\text{α}}^{\text{0}} {\text{, and α is a root of P(X), i.e., P(α) = α}}^{\text{5}} {\text{+ α}}^{\text{2}} \text{+ 1 = 0}$

After every symbol of the respective codewords has been clocked into the register R0, the remainder is available at respective latches 90,94 in response to two more clocks. During these clocks, a timing signal CW OUT clocks the latches. The output from the PAL array 56 is provided on a CHECKWORD OUT output from both latches 90,94. Because they share the same output, the latches are alternately enabled by the aforementioned EVEN and ODD signals. This CHECKWORD OUT output is provided during encode to the PISO converter 28 as shown in Figure 1, and to four "syndrome" latches 58 - 64 shown in Figure 3. The two symbols of the even checkwords are latched by latches 58,60 in response to successive signals CW1 and CW2. The two symbols of the odd checkwords are latched by latches 62,64 in response to successive signals CW1 and CW2. After the latches have been loaded with the checkword symbols, they are provided, two at a time to ROMs 66,68, on the ROM's ten bit address input lines. First the two even latches 58,60 are provided as co-ordinated by the EVEN signal. Next the two odd latches 62,64 are provided as coordinated by the ODD signal.

Each of the ROMS 66,68 are 1024 x 5 ramdon access. The contents of the ROM 66 comprise the 1024 five bit error values as indexed by the checkwords input on its ten bit address lines. The contents of the ROM 68 comprise the 1024 five bit error locations as indexed by the checkwords input on its ten bit address lines. If fewer than the maximum number of possible codeword symbols are used, as in the preferred embodiment where only sixteen data symbols are used and the maximum codeword length is thirty one symbols, each ROM's contents can be correspondingly reduced because of the reduced number of possible error values and locations.

The even error value is temporarily latched in a latch 70, and both even and odd error values are provided to the PAL array 56 for subsequent Galois addition to the erroneous read data symbol for the even and odd codewords of a group. The even and odd error locations are provided to respective count-up counters 74,76.

Next, the contents of the FIFO buffers 52,54 are alternately clocked out under control of EVEN and ODD signals both to the PAL array 56 and to a latch 78, which has a disable input connected to the PAL array. Normally, each READ DATA symbol clocked into it is clocked out to the PISO converter 40. However, if one of the counters 74 or 76 indicates an error location, the PAL array disables the output of the latch 78 and enables the CORRECTED READ DATA output to the PISO converter 40.

Figure 4 shows the portions of this process contained in the PAL array 56. The EVEN and ODD error values 96 are provided as one input to an XOR array 102. The other input to each is the output of the FIFO buffers 52,54. When an error location has been determined, the symbol in error is present at this input to the XOR array 102. The XOR array output is enabled under the control of an OR gate 100 whose inputs are the EVEN or ODD CORRECT ENABLE from the counters 74,76. The output of the OR gate 100 also disables the READ DATA of the latch 78. The output from the XOR array is provided on the CORRECTED DATA output to the PISO converter 40, thereby substituting for the symbol in error.

If no symbol is in error for a codeword, the remainder from division by the generator polynomial is zero. Zero could index an error location value that would not count out in counters 74 or 76, or alternatively, means (not shown) can be provided to detect all zero remainders and inhibit operation of the counters.

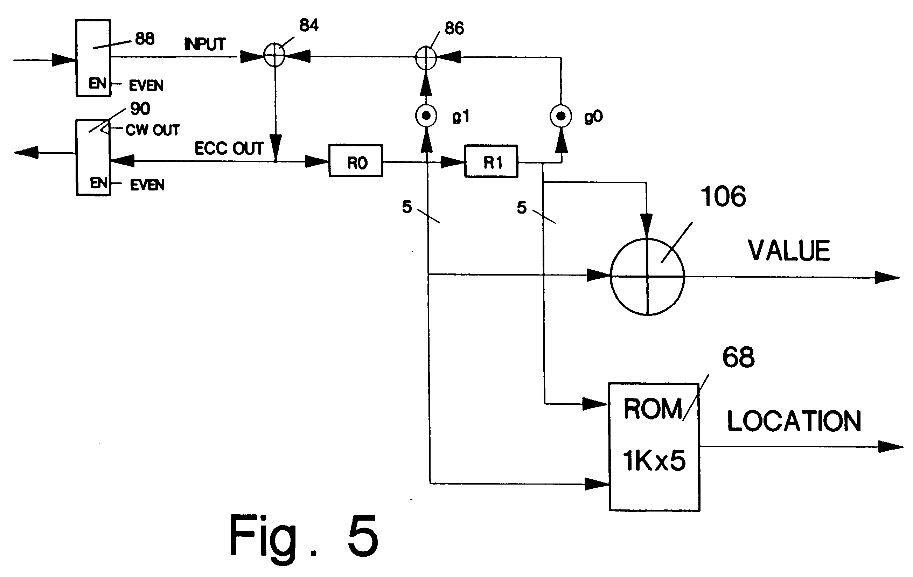

Figure 5 is an alternative arrangement where the roots of the generator polynomial are chosen such that a syndrome S₀ directly yields the error value. The even codeword is shown. An identical arrangement is made for the odd codeword. In this arrangement, the roots are α⁰ and α¹, yield a generator polynomial${\text{G(X) = X}}^{\text{2}} {\text{+ α}}^{\text{18}} {\text{X + α}}^{\text{1}} {\text{, and g1 = α}}^{\text{18}} {\text{= 00011 and g0 = α}}^{\text{1}} \text{= 00010.}$

Here all symbols of the codeword are clocked through a generator polynomial divider, the last two inputs being set to zero. The sum of the contents of the registers R0, R1 represent the remainder divided by X - α ⁰, which is syndrome S₀. The sum is formed by providing the outputs of these registers to an XOR array 106, the output S₀ of which is the error value.

The remainder, as before, also uniquely identifies an error location. Here the remainder is provided via the outputs of register R0, R1 to the address inputs of the ROM 68, as before, to index the error location.

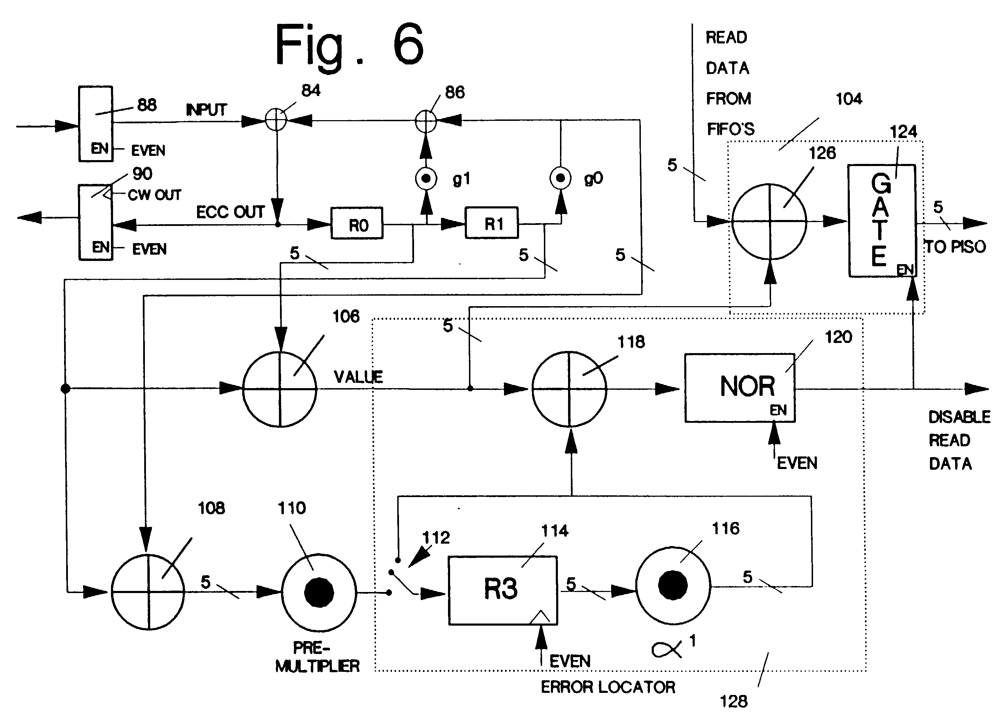

In a still further alternative arrangement, the syndrome S₁ may be used with the same generator polynomial to yield a value which provides an error location by the circuit shown in Figure 6. This additionally eliminates the need for the ROM 68.

As before, S₀, the output of the XOR 106, yields the error value. The division of the remainder by X - α¹ yields syndrome S₁. The co-efficient of the multiplier g0 is α ¹. Thus the remainder divided by X - α ¹ happens to be the output of the Galois multiplier g0 summed with the output of the register R0. This sum is provided by an XOR array 108, the input of which is the aforementioned outputs.

The error location may be found using the syndrome S₁ by comparing the product of S₁ and α ⁱ, i = 1,2...31 to the error value at the location i. The product may be determined by multiplying S₁ by α ⁱ.

A codeword in GF(2⁵) has many symbols as field elements, i.e. 31. In this embodiment, however, less than all possible codeword symbols are non-zero. Specifically, only 18, with only the 16 most significant of these comprising data. Thus the 31 - 18 = 13 most significant symbols of a codeword are not important to correct erroneous data. Therefore, the first possible data error location is 14 and the first thirteen locations can be ignored. This is achieved by multiplying S₁ by α ¹³, preferably, or alternatively by multiplying S₁ by α ¹ thirteen times. A pre-multiplier 110 multiplies S₁ by α ¹³.

A scaled syndrome S₁ ¹³, is input to an error locator 128 through a switch 112 and into a register R3. Thereafter, the switch 112 closes on a multiplier loop which includes the register R3 and an α ¹ multiplier 116. The output of the register R3 is multiplied by α ¹ as input to an XOR array 118 and the register R3. The other input of the XOR array 118 is the error value from the XOR array 106. If the scaled error location and error value are identical the corresponding data symbol is the one in error. Also, if the two inputs are equal, the output of the XOR array 118 is all zero. This is tested by a NOR gate 120, which goes high only when all inputs are zero.

As each data symbol (even or odd) is about to be forwarded to the PISO converter 40, its first input is provided to the latch 70 and to the XOR arrays 38 (Figure 1), the even one 104 of which is shown in Figure 6. The other input to the XOR array is the corresponding even or odd error value. In Figure 6, the error value from the XOR array 106 is input to an XOR 126, the output of which is gated by a gate array 124. The output of the gate array 124 is enabled when the NOR gate 120 indicates the detection of an even codeword error location. This output is connected to the CORRECTED READ DATA output of Figure 3. At the same time, the output of the NOR gate is also connected to the latch 78 and disables the output of that latch when an even error location is found. This results in the CORRECTED READ DATA substituting the READ DATA at the input to the PISO converter 40.

Each time the PISO converter 40 and the latch 78 are clocked for an even symbol, the register R3 is clocked to load a new power of S¹ and place on the input to the XOR array 118 the next power of S¹. The process continues until the entire even codeword is processed.

The apparatus shown in Figure 6 is for the even codeword only. It is repeated for the odd codeword. Each also has means for enabling the NOR gate 120 output only when a corresponding even or odd symbol is present at the latch 78.

Figure 7 shows a variation on the even de-coder segment of Figure 5. As the syndromes, as well as the remainder, in combination are uniquely associated with a single error location, they are provided from the XOR arrays 106 (S₀), 108 (S₁) to the ROM 68 to look up pre-associated error locations.

Figure 8 shows a variation on Figures 5, 7 and 3 wherein the syndromes are employed to look up both the pre-associated error values and location from the ROMs 66,68 respectively.

As shown in these Figures, the syndromes are formed by dividing the remainder by the roots of the generator polynomial. There are other ways of determining syndromes from a codeword. One example, shown in US-A-4,584,686, divides the codeword itself by the roots of the generator polynomial.

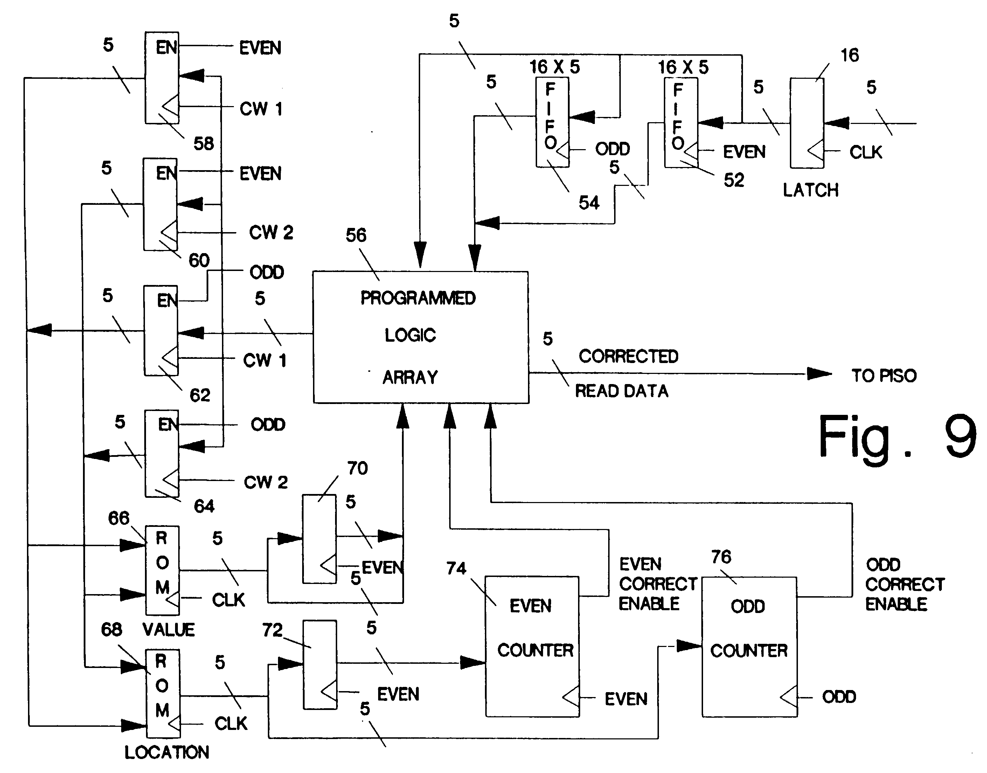

Figure 9 is a schematic view of an alternative inter-leaved de-coder from that of Figure 3 wherein the latch 78 is eliminated. Here both the even and odd symbols are provided to the PAL array 56 as before, and output unmodified if the symbol is not in error, but output corrected if in error. All the data of the FIFO buffers is funnelled through the XOR gate of the PAL array 56.

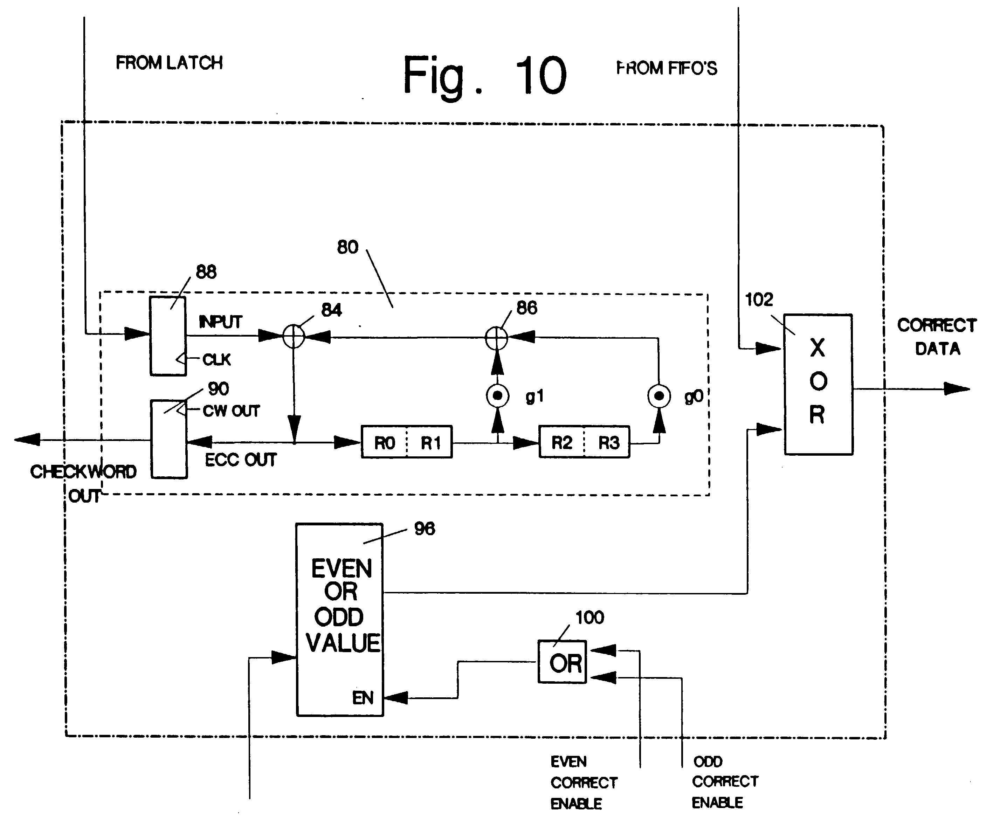

Figure 10 shows this variation, plus an alternative inter-leaved encoder/de-coder 80. Here both even and odd symbols from the FIFO buffers are input to the XOR array 102. The other input is from the error value 96, whose output is normally all zeroes unless enabled by the OR gate 100 when either an even or odd error location has been determined by the counters 74,76 (Figures 3 or 9). When enabled by the OR gate 100, the EVEN or ODD error value then present passes to the XOR array 102 where it corrects the data symbol in error from the FIFO buffer. In both cases, the results of the XOR array are correct, and forwarded to the PISO converter 40.

The encoder/de-coder 80 replaces the pair of encoder/de-coders 80,82 from Figure 4.

In this Figure, registers R0, R1 and R2, R3 are shift registers which have two array cells. Essentially, at each clock, the register R0 copies the five bits on its input and the register R1 copies the five bits in the register R0 and places these bits on its output. The registers R2, R3 operate in the same way. In this manner, both inter-leaved data segments or codewords are input each clock through the latch 88, but are effectively separated into two separate codewords by the shift registers R1, R0 and R2, R3. The output is the same. The arrangement reduces the need for duplicate Galois multipliers, g0, g1, etc.

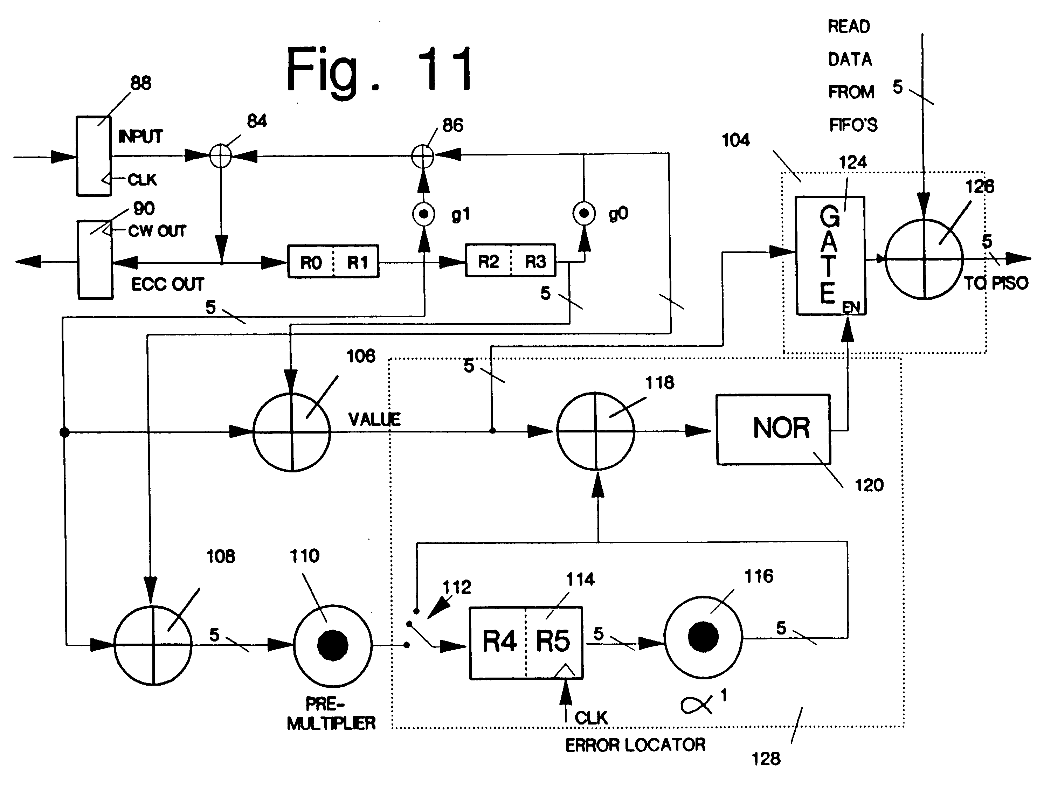

Figure 11 is a preferred variation from the error locator arrangement of Figure 6 employing the shift register arrangement of Figure 10. Here the register R3 of an error locator 128 has been replaced with shift registers R4, R5 which function identically to shift registers R0, R1 and R2, R3. On alternate clocks, an even or odd error location is available from the output of the NOR gate 120 and the error value on the output of the XOR array 106. If the NOR gate 120 indicates an error location is present, it enables the gate 124 to pass the error value through the XOR array 126 which corrects the data symbol in error. However, if an error location is not present, the gate 124 is not enabled and outputs all zeroes, and the data from the FIFO buffer passes through the XOR array 126 uncorrected.

## Claims

1. On the fly error correction apparatus for correcting errors in codewords, grouped in multi-bit symbols, each codeword comprising encoded data and check-word symbols, said apparatus comprising
means (24) for receiving said codewords;
means (30) for applying a generator polynomial to each of said codewords to calculate syndromes and/or remainders and to derive therefrom a correction value and location; and
means (13, 38, 34, 36) for reading out the respective codeword from the means for receiving and if there is an error, correcting the error using the correction value and the location; characterised in that:
a single symbol error correcting code is used for generating said codewords;
first and second successive codewords are interleaved symbol by symbol;
said applying means processes said first and second codewords simultaneously in two parallel channels, each channel comprising a polynomial divider (80, 82) and means for deriving the correction value and location.

2. An error correction apparatus as claimed in claim 1, further comprising a memory (34, 66, 68) for storing the correction values and locations.

3. An error correction apparatus as claimed in Claim 1 or 2, in which the applying means comprises a first XOR gate (84) having a first input for receiving the codeword, a second input for receiving the output of a second XOR gate (86) and an output coupled to a first register (R0), the output of the first register (R0) is coupled to the input of a first multiplier (g1) and a second register (R1), the output of the first multiplier provides the first input of the second XOR gate (86), the output of the second register (R1) is coupled to the input of a second multiplier (g0) and the output of which provides the second input for the second XOR gate (86).

4. An error correction apparatus as claimed in claim 3 when dependent on claim 2, in which the sum of the outputs of the first and second registers (R0, R1) is used to address the memory to obtain the correction value and the location.

5. An error correction apparatus as claimed in claim 3, in which the output of the first XOR gate (84) provides the remainder.

6. An error correction apparatus as claimed in claim 3, in which the sum of the outputs of the first and second registers (R0, R1) provides the syndrome corresponding to the correction value and the outputs of the first and second registers (R0, R1) provides the remainder.

7. An error correction apparatus as claimed in claim 3 when dependent on claim 2, in which the sum of the outputs of the first and second registers (R0, R1) provides the syndrome corresponding to the correction value and the sum of the first and second registers (R0, R1) is used to address the memory to obtain the location.

8. An error correction apparatus as claimed in any preceding claim in which each channel has a respective polynomial divider.

9. An error correction apparatus as claimed in claim 8 when dependent on any one of claims 3 to 7 in which the applying means comprises two first and second XOR gates (84, 86), first and second registers (R0, R1) and first and second multipliers (g0, g1), each associated with a respective channel.

10. An error correction apparatus as claimed in any one of claims 1 to 7 in which the two parallel channels share a single polynominal divider.

11. An error correction apparatus as claimed in claim 10 when dependent on any one of claims 3 to 7, in which the first register is a first shift register (R0, R1) and the second register is a second shift register (R2, R3).

12. An error correction apparatus as claimed in claim 11 in which the first and second shift registers (R0, R1, R2, R3) are two cell shift registers.

## Patentansprüche

1. Vorrichtung zur fliegenden Korrektur von Fehlern in Codeworten, die in Mehr-Bit-Symbolen gruppiert sind, wobei jedes Codewort kodierte Daten und Prüfwort-Symbole umfaßt, und wobei die Vorrichtung folgende Teile umfaßt:
- Einrichtungen (24) zum Empfangen der Codeworte,
- Einrichtungen (30) zum Anwenden eines Generator-Polynoms auf jedes der Codeworte zur Berechnung von Syndromen und/ oder Restwerten und zur Ableitung eines Korrekturwertes und einer Korrekturstelle hieraus, und
- Einrichtungen (13,38,34,36) zum Auslesen des jeweiligen Codewortes von den Einrichtungen zum Empfangen, und wenn ein Fehler vorliegt, zum Korrigieren des Fehlers unter Verwendung des Korrekturwertes und der Korrekturstelle,
dadurch gekennzeichnet, daß
- ein Einzelsymbol-Fehlerkorrekturcode zur Erzeugung der Codeworte verwendet wird,
- erste und zweite aufeinanderfolgende Codeworte Symbol für Symbol miteinander verschachtelt sind,
- die Einrichtungen zum Anwenden die ersten und zweiten Codeworte gleichzeitig in zwei parallelen Kanälen verarbeiten, wobei jeder Kanal einen Polynom-Dividierer (80,82) und Einrichtungen zum Ableiten des Korrekturwertes und der Korrekturstelle umfaßt.

2. Fehlerkorrekturvorrichtung nach Anspruch 1,
die weiterhin einen Speicher (34,66,68) zum Speichern der Korrekturwerte und Korrekturstellen umfaßt.

3. Fehlerkorrekturvorrichtung nach Anspruch 1 oder 2,
bei der die Einrichtungen zum Anwenden ein erstes XOR-Verknüpfungsglied (84) mit einem ersten Eingang zum Empfang des Codewortes, mit einem zweiten Eingang zum Empfang des Ausganges eines zweiten XOR-Verknüpfungsgliedes (86) und mit einem mit einem ersten Register (R0) gekoppelten Ausgang umfassen, wobei der Ausgang des ersten Registers (R0) mit dem Eingang eines ersten Multiplizierers (g1) und eines zweiten Registers (R1) gekoppelt ist, wobei der Ausgang des ersten Multiplizierers den ersten Eingang des zweiten XOR-Verknüpfungsgliedes (86) bildet, während der Ausgang des zweiten Registers (R1) mit dem Eingang eines zweiten Multiplizierers (g0) gekoppelt ist, dessen Ausgang den zweiten Eingang für das zweite XOR-Verknüpfungsglied (86) liefert.

4. Fehlerkorrekturvorrichtung nach Anspruch 3 unter Rückbeziehung auf Anspruch 2,
bei der die Summe der Ausgänge der ersten und zweiten Register (R0,R1) zur Adressierung des Speichers zur Gewinnung des Korrekturwertes und der Korrekturstelle verwendet wird.

5. Fehlerkorrekturvorrichtung nach Anspruch 3,
bei der der Ausgang des ersten XOR-Verknüpfungsgliedes (84) den Restwert liefert.

6. Fehlerkorrekturvorrichtung nach Anspruch 3,
bei dem die Summe der Ausgänge der ersten und zweiten Register (R0,R1) das dem Korrekturwert entsprechende Syndrom liefert, während die Ausgänge der ersten und zweiten Register (R0,R1) den Restwert liefern.

7. Fehlerkorrekturvorrichtung nach Anspruch 3 unter Rückbeziehung auf Anspruch 2,
bei der die Summe der Ausgänge der ersten und zweiten Register (R0,R1) das dem Korrekturwert entsprechende Syndrom liefert und die Summe der ersten und zweiten Register (R0,R1) zur Adressierung des Speichers zur Gewinnung der Stelle verwendet wird.

8. Fehlerkorrekturvorrichtung nach einem der vorhergehenden Ansprüche,
bei der jeder Kanal einen jeweiligen Polynom-Dividierer aufweist.

9. Fehlerkorrekturvorrichtung nach Anspruch 8 unter Rückbeziehung auf einen der Ansprüche 3 bis 7,
bei der die Einrichtung zum Anwenden zwei erste und zweite XOR-Verknüpfungsglieder (84,86), erste und zweite Register (R0,R1) und erste und zweite Multiplizierer (g0,g1) umfaßt, die jeweils einem jeweiligen Kanal zugeordnet sind.

10. Fehlerkorrekturvorrichtung nach einem der Ansprüche 1 bis 7,
bei der die beiden parallelen Kanäle sich einen einzigen Polynom-Dividierer teilen.

11. Fehlerkorrekturvorrichtung nach Anspruch 10 unter Rückbeziehung auf einen der Ansprüche 3 bis 7,
bei der das erste Register ein erstes Schieberegister (R0,R1) und das zweite Register ein zweites Schieberegister (R2,R3) ist.

12. Fehlerkorrekturvorrichtung nach Anspruch 11,
bei der die ersten und zweiten Schieberegister (R0,R1,R2,R3) zwei Zellen aufweisende Schieberegister sind.

## Revendications

1. Appareil de correction simultanée d'erreurs pour corriger des erreurs dans des mots codes, groupés en symboles multi-bit, chaque mot code comprenant des données encodées et des symboles de mots de contrôle, ledit appareil comprenant :
des moyens (24) pour recevoir lesdits mots codes ;
des moyens (30) pour appliquer un polynôme générateur à chacun desdits mots codes pour calculer des syndromes et/ou des restes et pour déduire de ceux-ci une valeur de correction et un emplacement ; et
des moyens (13, 38, 34, 36) pour extraire le mot code respectif des moyens de réception et, s'il y a une erreur, corriger l'erreur en utilisant la valeur de correction et l'emplacement ; caractérisé en ce que :
un code de correction d'erreurs à symbole unique est utilisé pour générer lesdits mots codes ;
les premier et second mots codes successifs sont intercalés symbole par symbole ;
lesdits moyens d'application traitent lesdits premier et second mots codes simultanément dans deux canaux parallèles, chaque canal comprenant un diviseur polynomial (80, 82) et des moyens pour déduire la valeur de correction et l'emplacement.

2. Appareil de correction d'erreurs selon la revendication 1, comprenant de plus une mémoire (34, 66, 68) pour stocker les valeurs de correction et les emplacements.

3. Appareil de correction d'erreurs selon la revendication 1 ou 2, dans lequel les moyens d'application comprennent une première porte OU EXCLUSIF (84) ayant une première entrée pour recevoir le mot code, une deuxième entrée pour recevoir la sortie d'une seconde porte OU EXCLUSIF (86) et une sortie couplée à un premier registre (R0), la sortie du premier registre (R0) est couplée à l'entrée d'un premier multiplicateur (g1) et d'un second registre (R1), la sortie du premier multiplicateur fournit la première entrée de la seconde porte OU EXCLUSIF (86), la sortie du second registre (R1) est couplée à l'entrée d'un second multiplicateur (g0) et dont la sortie fournit la seconde entrée pour la seconde porte OU EXCLUSIF (86).

4. Appareil de correction d'erreurs selon la revendication 3 quand elle est dépendante de la revendication 2, dans lequel la somme des sorties des premier et second registres (R0, R1) est utilisée pour adresser la mémoire pour obtenir la valeur de correction et l'emplacement.

5. Appareil de correction d'erreurs selon la revendication 3, dans lequel la sortie de la première porte OU EXCLUSIF (84) fournit le reste.

6. Appareil de correction d'erreurs selon la revendication 3, dans lequel la somme des sorties des premier et second registres (R0, R1) fournit le syndrome correspondant à la valeur de correction et les sorties des premier et second registres (R0, R1) fournissent le reste.

7. Appareil de correction d'erreurs selon la revendication 3 quand elle est dépendante de la revendication 2, dans lequel la somme des sorties des premier et second registres (R0, R1) fournit le syndrome correspondant à la valeur de correction et la somme des premier et second registres (R0, R1) est utilisée pour adresser la mémoire pour obtenir l'emplacement.

8. Appareil de correction d'erreurs selon l'une quelconque des revendications précédentes, dans lequel chaque canal a un diviseur polynomial respectif.

9. Appareil de correction d'erreurs selon la revendication 8, quand elle est dépendante de l'une quelconque des revendications 3 à 7, dans lequel les moyens d'application comprennent deux première et seconde portes OU EXCLUSIF (84, 86), deux premier et second registres (R0, R1) et deux premier et second multiplicateurs (g0, g1), chacun associé à un canal respectif.

10. Appareil de correction d'erreurs selon l'une quelconque des revendications 1 à 7, dans lequel les deux canaux parallèles partagent un seul diviseur polynomial.

11. Appareil de correction d'erreurs selon la revendication 10 quand elle est dépendante de l'une quelconque des revendications 3 à 7, dans lequel le premier registre est un premier registre à décalage (R0, R1) et le second registre est un second registre à décalage (R2, R3).

12. Appareil de correction d'erreurs selon la revendication 11, dans lequel les premier et second registres à décalage (R0, R1, R2, R3) sont des registres à décalage deux cellules.
